# EUROPEAN PATENT APPLICATION

(11) **EP 1 853 005 A1**
(43) Date of publication of application: **07.11.2007**
(21) Application number: 06405189.9
(22) Date of filing: 01.05.2006
(51) Int. Cl.: H04L 12/28

(54) **Method and network-based system for transferring information over a network to destination devices**

(71) Applicant: Anagram Technologies SA, 1028 Preverenges (CH)
(72) Inventor: Heeb, Thierry, 1044 Fey (CH)
(74) Representative: Rutz, Peter

(57) **Abstract**

The method and network-based system allow transferring information, particularly audio information from a centralised source unit (1), particularly an audio source unit, in digital form over a network (2) to at least one destination unit (3), particularly to an audio destination unit, in which the transferred data are further processed to provide an analogue signal; comprising the steps of
a) providing in the centralised source unit (1) a first digital signal, such as a PCM signal, that has been derived from a first analogue signal;
b) forwarding the first digital signal in the centralised source unit (1) to the input of a modulator (131), which transforms the first digital signal into a second digital signal that consists of a bit stream, whose mean-value represents the information contained in the first digital signal;
c) transferring the second digital signal over said network (2) to the destination unit (3); and
d) forwarding the second digital signal in the destination unit (3) to a low pass filter (33) in order to gain a second analogue signal that corresponds to the first analogue signal.

## Description

The present invention relates to a method and a network-based system that allow transferring information content, particularly audio information, or, more generally, information relating to recorded analogue signals, from a centralised source unit, particularly an audio source unit, in digital form over at least one network to at least one destination unit, particularly to an audio destination unit, in which the transferred data are further processed to provide an analogue signal.

The present invention relates in particular to a network-based system that allows transferring audio information, which is available in the audio source unit in any digital or analogue format, in a digital format over the network to at least one audio destination unit, where the audio information is forwarded to a switching stage of a digital audio amplifier, typically a class-D amplifier or a low pass filter followed by an analogue amplifier.

The present invention further relates to a network-based system that allows transferring digital audio information over a wired network such as a wired bus system or a switched network by means of a connection-oriented service, e.g. in a circuit switched network, or by means of a connectionless service, e.g. in a packet switching network such as an IP-network or a wireless optical or radio frequency network.

### BACKGROUND OF THE INVENTION

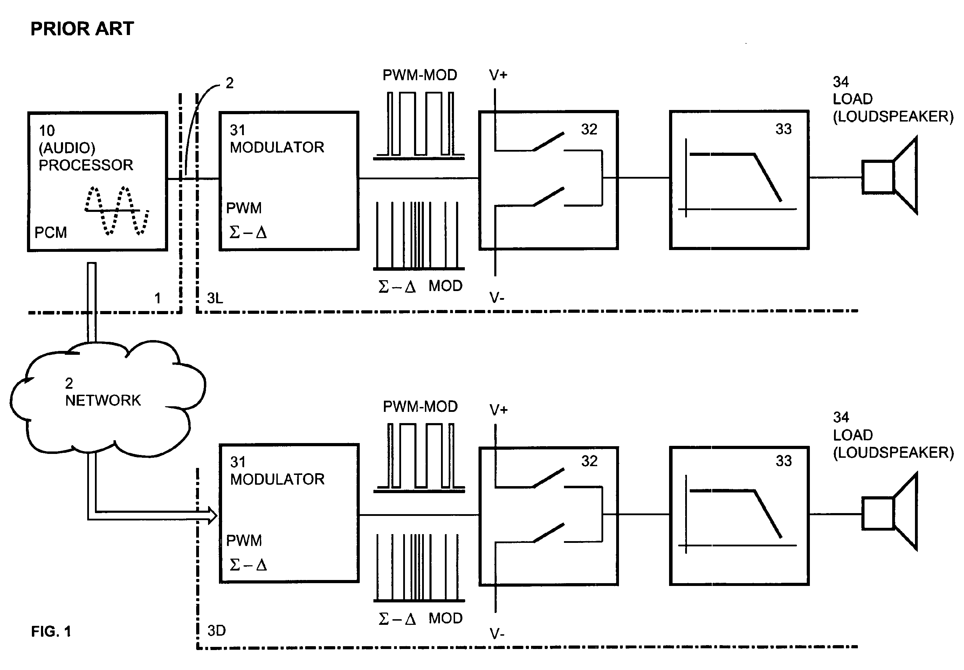

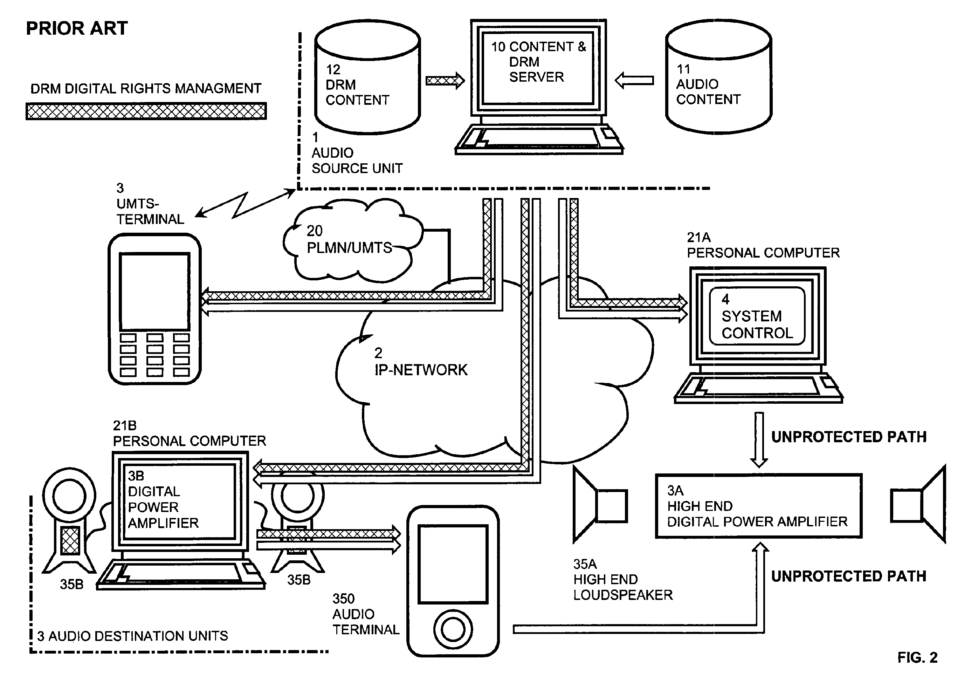

The principles of Digital Signal Processing used for information transmission systems are described in [1], Peter Gerdse, Peter Kröger, Digitale Signalverarbeitung in der Nachrichtenübertragung, 2nd Edition, Berlin 1997. According to [1], page 2, fig. 1.1 the basic principle illustrated showing that an analogue signal is digitised to provide a sequence of binary data, i.e. a digital signal, to a processing unit, which forwards the processed digital signal to a digital to analogue converter, which provides an analogue signal. Means for performing the above steps are described in [1], page 10, figure 2.5. These means typically are a sample and hold units, AD-converters, digital processing units, DA-converters and interpolation filters.

Within the transmission chain, the digital signal can be filtered, modulated, and thus brought into various forms suitable for transmission over a specific network.

In the recent years, digital signal processing techniques were also applied in the field of Digital Power Amplification.

A comparison of current solutions in the field of Digital Power Amplification is detailed in [2], R. Esslinger, G. Gruhler, R.W. Stewart, Digital Power Amplification based on Pulse-Width Modulation and Sigma-Delta Loops, Signal Processing Division, Dept. of Electronic and Electrical Engineering, University of Strathclyde, Glasgow G1 1XW, Scotland. According to [2], a digital power amplifier provides a direct conversion of a digital signal into the analogue domain where the signal has the capability to provide high-power to a low impedance load such as a loudspeaker. [2], figure 1 shows the basic outline of such a system. The first stage performs interpolation of a Nyquist rate PCM (pulse coded modulation) signal to produce an oversampled PCM digital signal. This signal is then fed into a modulation circuit. The modulation is typically sigma delta (Σ-Δ) or pulse width modulation (PWM) and thus produces a final signal that has only a finite number of voltage levels, usually two or three. Further, according to [2], the key aim of the modulation is to produce a signal where the information of the PCM signal value is represented by the mean-value of the bit stream. This allows the original signal information to be extracted by a simple analogue low pass filter, which can be constructed from passive components like inductors and capacitors. [2], figure 2 shows how the mean value can be represented by digital pulses.

A wide range of low bandwidth, high resolution, Σ-Δ ADCs (series AD 77XX) is available for example from Analog Devices Inc. (http://www.analog.com/en/index.html). Along with the ADC, these devices typically contain current sources, a multiplexer, a PGA and analogue input buffers on board. D/A and A/D Converters are further described in [3], Richard C. Dorf, The Electrical Engineering Handbook, 2nd Edition, CRC Press, 1997 Boca Raton, chapter 32, page 841 ff.

The two or three level modulated signals can have a variable width and a variable or fixed cycle-time or the width can be fixed and there is no specific cycle-time. A large width or a high number of pulses represents a greater input value than a small pulse-width or a low number of pulses. Amplifiers for these two or three level signals belong to the so-called class-D amplifiers, because the power stages have no linear area of operation.

As shown in figure 1 below, the PCM-signal can be forwarded from a signal source 1, e.g. a signal processor 10, over a bus system or a wired network to a local amplifier 3L and over a circuit switched network or packet switching network 2 to a distant digital amplifier, which comprises said Pulse-Width or Sigma-Delta Modulator (the drawings show both alternatives and examples for the PWM- and Σ-Δ- modulated signals), from which the modulated signals are forwarded to a switching stage 32, and used there to activate at least one pair of switches that are connected on the one side to supply voltages V+, V- and on the other side to a low pass filter 33 that is connected to a load such as a loudspeaker 34.

The amplifiers 3L and 3d shown in figure 1 are class-D amplifiers, which can be designed to provide the same performance as known class A / B / A-B amplifiers.

Differences between class A / B / A-B and class D amplifiers are described for example in [4], US 2006/0044057 and [5], US 5'898'340.

According to [5], the volume of the digital power amplifier can be controlled by controlling the level of the supply voltages V+, V-.

Digital audio amplifiers were introduced on the market about thirty years ago (e.g. Sony TA-N88). Modern digital audio amplifiers such as the Sharp SM-SX 100 achieve very high performance levels.

Hence, as shown in figure 1, with this technique it is possible to distribute audio signals in a PCM-format to a number of local and distant digital power amplifiers 3L, 3D.

Figure 2 shows a network-based system designed for transferring audio information. This system allows distributing original audio information in PCM signals or encoded or compressed PCM signals (i.e. by using MP3, WMA, AAC, etc compression encoding and decoding) issued by a first network terminal, e.g. a content & DRM server 10 provided in an audio source unit 1, over a packet switching network 2, e.g. an IP-network, to a number of network terminals 21, e.g. personal computers, which forward the received audio information, preferably provided in PCM format to digital power amplifiers 3A, 3B or to D/A converters followed by an analogue amplifier. As described above, the modulators provided in the digital power amplifiers 3A, 3B transform the received PCM signals into corresponding streams of binary data.

Content information is further forwarded over a mobile telecommunication network PLMN, e.g. operating according to GSM or UMTS standards, to mobile terminals.

The network terminal 21B further forwards the received original audio information in PCM or encoded format to a handheld audio terminal 350, which typically is equipped with a large storage media, such as hard or fixed disk and which is designed to deliver an analogue audio signal to ear phones or an analogue audio signal or a digital PCM-signal further to the analogue or digital input of the audio amplifier 3A.

From the mentioned storage media, the original audio information can illegally be accessed or distributed or copied to other storage media without the control or consent of the owner of the audio information, thus often violating regulations of copyright protection law. Hence, it would be desirable for owners and lawful distributors to find a solution to this problem on a technical and not on a legal basis.

As illustrated in figure 2 the network-based system is protected by DRM-technologies, which are described in [6], WO 2006/041590. According to [6], "Digital Rights Management" (DRM) is a mechanism for ensuring that digital content is properly handled in accordance with the rights granted by either a content owner or a content provider. According to the DRM-method disclosed in [6]; scrambled digital content is descrambled within a subscriber terminal device, by conducting digital rights management by a first component of the subscriber terminal device to determine whether entitlements needed for accessing digital content in a descrambled format are available to the subscriber terminal device; and deriving a key within a second component of the subscriber terminal device logically separate from and independent of the first component in response to determining that all of the entitlements are needed for accessing the digital content are available to the subscriber terminal device, the key being used to decrypt service keys used for descrambling the scrambled digital content.

Hence, according to [6], the DRM-measures cover the network-based system shown in figure 2 from the content server to the subscriber terminals 21, 350. The path from the subscriber terminals 21, 350 to the audio amplifier remains unprotected.

Further, though the technology presented in figures 1 and 2 has been well established, a drawback is the need for rather expensive system parts, particularly for high end digital audio amplifiers such as the Sharp SM-SX 100, which comprises a Σ-Δ-modulator, which receives analogue signals directly or PCM-signals over an oversampling digital filter. As a result a drawback of the digital audio amplifiers, which have practically no significant performance limitation, is the cost of manufacturing. For distributed systems, the peripheral high performance digital audio amplifiers are an important cost factor.

It would therefore be desirable to provide an improved method and an improved network-based system, that are designed for transferring information relating to signals, particularly content such as audio information, from a centralised source unit, particularly an audio source unit, in digital form over a network to at least one destination unit, particularly to an audio destination unit, in which the transferred data are further processed to provide an analogue signal, while avoiding in particular the above discussed drawbacks of legal, technical and financial nature.

It would be desirable in particular to provide an improved network-based system that can be established at low cost in any size for global use or use at the home of a private owner.

### SUMMARY OF THE INVENTION

The above and other objects of the present invention are achieved by a method and a network-based system according to claim 1 and 11 respectively.

The inventive method and the inventive network-based system allow transferring information, particularly audio information from a centralised source unit, particularly an audio source unit, in digital form over a network to at least one destination unit, particularly to an audio destination unit, in which the transferred data are further processed to provide an analogue signal.

According to the present invention
a) providing in the centralised source unit 1 a first digital signal, such as a PCM signal, that has been derived from a first analogue signal;
b) forwarding the first digital signal in the centralised source unit to the input of a modulator, which transforms the first digital signal into a second digital signal that consists of a bit stream, whose mean-value represents the information contained in the first digital signal;
c) transferring the second digital signal over said network to the destination unit; and
d) forwarding the second digital signal in the destination unit to a low pass filter in order to gain a second analogue signal that corresponds to the first analogue signal.

Hence the present invention allows transferring information derived from an analogue signal over a network, e.g.
- a wired network such as a wired bus system; or a
- a wireless or wired switched network providing connection-oriented services; or
- a wireless or wired packet switching network;
from a centralised source unit, e.g. the content server of a DRM-system, to numerous destination units in which the transferred signals are further processed or digitally amplified by means of a switching stage and a low pass filter.

For example the second digital signal can be applied in the destination unit to the switching stage of a digital power amplifier that is connected to a low pass filter, which provides an output signal to a loudspeaker.

However analogue signals may also be used for other purposes, e.g. for controlling networked systems particularly distributed systems.

Concentrating the modulators, which are normally part of a digital amplifier, in the centralised source unit provides several advantages.

In home entertainment systems or in larger systems as used in cinemas or theatres the decentralised destination units do not require signal processing units. Preferably all mathematical modifications of the digital signals are performed in the centralised source unit, where corresponding processing hardware and software is readily available. Hence, centrally expanding the processing power results in small cost increases compared to decentrally establishing processing capabilities in the destination units. The digital signals can therefore be processed in the centralised source unit with high accuracy at low cost. As a result overall cost of the network-based system can significantly be reduced.

Further control maintenance and updating of such a system can easily be performed since most modifications can exclusively be performed in the centralised source unit. The destination units however comprise simple power stages

Still further, the second digital signal that is produced by an individual modulator by means of pulse width modulation or sigma-delta modulation or a derivative thereof or by means of a sample rate conversion, is not available in a suitable form for copying, although it may be presented in the highest possible quality. Hence, unlawful users will not have access to the original content, e.g. audio content, along the whole transmission chain. Access to transferred content would practically be available in the analogue domain at the output of the low pass filter only.

Bit streams of the second digital signals produced by the modulators contained in the centralised source unit can be multiplexed, encoded, encrypted and/or packetised in the centralised source unit and de-multiplexed, decoded, decrypted and/or de-packetised in the destination unit according to any known method, as described for example in [6].

For packet-switching systems, control frames can be introduced into the packet stream with little effort, thus allowing centralisation of the control circuitry in the centralised source unit, thus further cutting down expenses for decentralised circuitry.

Since variations of transmission times and/or differences or drifts of clock frequencies (f2 = n * fs1, fs3) used in the centralised source unit and in the destination unit may occur, the bit stream of the second digital signal is forwarded to a buffer such as a FIFO-buffer. If the buffer is large enough and the drifts of the clock frequencies are small and the clock frequencies are identical in average no overflow will occur. However, if the frequencies constantly deviate a correction is required which can preferably be performed as follows.

The clock frequency of the centralised source unit can be recovered in the destination unit, preferably by means of a phase locked loop. Hence, with this method, the clock frequency of the destination unit is firmly locked to or following the clock frequency of the centralised source.

As an alternative, the content level in the buffer is measured and a corresponding control signal is sent to a sample rate converter provided in the centralised source unit, which adjusts the clock frequency for the related modulator in such a way that the content level in the buffer remains within a given range.

Still further a common network time and/or clock may advantageously be used for synchronising all relevant system clocks in the centralised source unit and the individual destination units.

Still further, delays occurring in the network-based system can be measured and compensation in order to maintain a phase coherent operation for all system parts.

Phase coherent operation may also be guaranteed by using a common system time that is locally maintained in clock units or timers and that allows synchronisation of the play out of the individual bit streams or allowing calculating different start times in order to compensate for propagation delays outside the network-based system (e.g. in the event that a loudspeaker has been placed at a place that is farther a part from the audience than the other loudspeakers, which will be assigned a corresponding delay.

If all relevant delays have already been measured, the start time can be calculated in the centralised source unit in advance.

A suitable common clock time can be determined in the centralised source unit in advance based on known delays that have been measured within the network-based system. The determined common clock time can be forwarded to the destination units within a frame such as a header contained in the bit stream of the second digital signal or over a separate control channel.

If the relevant delays are not known, a suitable common clock time can be determined after the start of the transfer of the bit stream of the second digital signal, and after the detection of a header in the destination units, that has been signalled to the centralised source unit, which then forwards the determined common clock time to the destination units over a separate control channel.

The network-based system can be used on the one hand particularly for private or public audio or multimedia entertainment systems and on the other hand for commercial or non-commercial distribution systems, particularly DRM-distribution systems. Hence, the application of the inventive solution is scalable from a small home application to a global application with unlimited subscribers.

### SUMMARY OF THE INVENTION

The above and other objects of the present invention are achieved by a method and a network-based system according to claim 1 and 11 respectively.

### The inventive method and network-based system allow

### BRIEF DESCRIPTION OF THE DRAWINGS

Some of the objects and advantages of the present invention have been stated, others will appear when the following description is considered together with the accompanying drawings, in which:
- Figure 1: shows a known network based system that allows transferring digitals signal containing audio information from a centralised source unit 1 over a wired and packet switching network 2 to a first and a second destination unit 3L, 3D, in which the digital signal is forwarded to a digital audio amplifier consisting of a modulator 31, a switching stage 32, and a low pass filter 33;
- Figure 2: shows a shows a known network-based system with a centralised source unit 1 that allows distributing PCM-signals or compressed PCM-signals issued by a first network terminal, e.g. a content & DRM server 10, over a packet switching network 2, e.g. an IP-network, to a number of network terminals 21 or subscribers;
- Figure 3: shows an inventive network-based system with a centralised source unit 1 comprising at least one modulator 131, which modulates a first digital signal d1 that has been provided from an audio processor 10 and which forwards a second digital d21, d22 to a first and a second destination unit 3L, 3D, in which the digital signal is forwarded to a digital audio amplifier consisting of a switching stage 32, and a low pass filter 33;
- Figure 4: shows the inventive network-based system of figure 3 with a buffer 36 provided (at least) in the destination unit 3D and with synchronised (symbolically shown) clock units 17, 37 in the centralised source unit 1 and in the destination unit 3D;
- Figure 5: shows the inventive network-based system of figure 4, with a clock recovery unit PLL in the clock unit 37 of the destination unit 3D;
- Figure 6: shows the inventive network-based system of figure 4, with a clock and measuring unit 37 provided in the destination unit 3D, which provides a fixed clock signal to the buffer 36 and which signals the content level of the buffer 36 to the clock unit of the centralised source unit 1 or directly to a sample rate converter 15, which adjusts the sampling frequencies of the related modulator 131 in order to keep the content level within a predetermined range;
- Figure 7: shows the inventive network-based system of figure 4, with a network time base control system that synchronises local clocks and times in the centralised source unit 1 and in the destination units 3;
- Figure 8: shows the multiplexing architecture of an inventive network-based system comprising a centralised source unit 1 and four destination units 3D1, ..., 3D4;
- Figure 9: shows the inventive network-based system of figure 7 with a central control unit 1000 provided in the centralised source unit 1 that communicates with the local control unit of the destination units 3D via a separate control channel;
- Figure 10: shows the inventive network-based system of figure 7 with the central control unit 1000 provided in the centralised source unit 1 forwarding control signals in-band or interleaved within the packetised modulated bit stream to the local control unit of the destination units 3D;.
- Figure 11: shows a sample rate converter 15/131 provided in the centralised source unit 1, that is used for sample rate conversion and/or signal modulation; and.
- Figure 12: shows the network-based system of figure 2 after the implementation of the inventive solution.

### DETAILED DESCRIPTION OF THE PREFERRED EMBODIMENTS

Figure 1 and figure 2 have been described above.

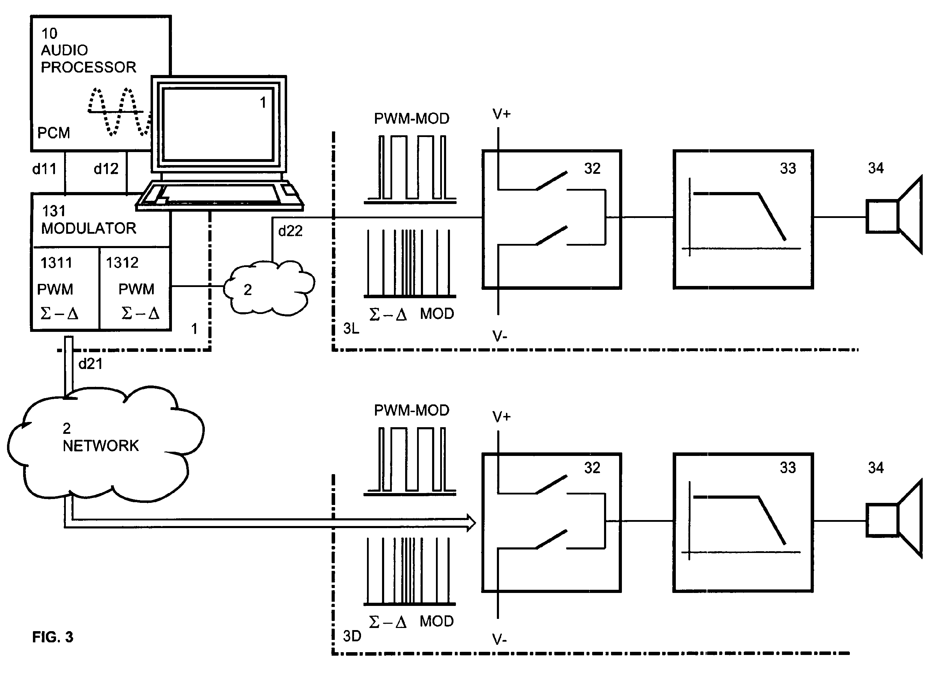

Figure 3 shows an inventive network-based system with a centralised source unit 1 comprising at least one modulator 131, which modulates a first digital signal d11 ; d12 that has been provided from an audio processor 10 and which forwards a corresponding second (modulated) digital d21; d22 to a first and to a second destination unit 3L, 3D, in which the digital signal is forwarded to a digital audio amplifier consisting of a switching stage 32, and a low pass filter 33 or, as an alternative, to a preferably active low pass filter that provides a low level analogue signal to an analogue amplifier.

Instead of providing modulators decentrally in the peripheral destination units, as shown in figure 1, a modulator 131 with individual modulator modules (or individual modulators) is provided in the centralised source unit 1, which may be implemented within a single computer system 1. Since the computing power of modern computer systems 1 is extremely high, said modulators 131 or 1311, 1312 can be realised with high quality at low cost, thus avoiding the replication of corresponding processing units in the peripheral destination units.

The modulation performed by the modulators 131 or modulator modules 1311, 1312 is preferably a pulse width modulation or a sigma-delta modulation or a derivative thereof. Both alternatives are illustrated in figure 3.

The resulting second digital signal, which directly represents the audio content can be multiplexed, encoded, encrypted and/or, if required, packetised according to a known method and then transferred over the network to the destination units 3. Packetising of encoded and encrypted data is described for example in [7], US 6'990'202.

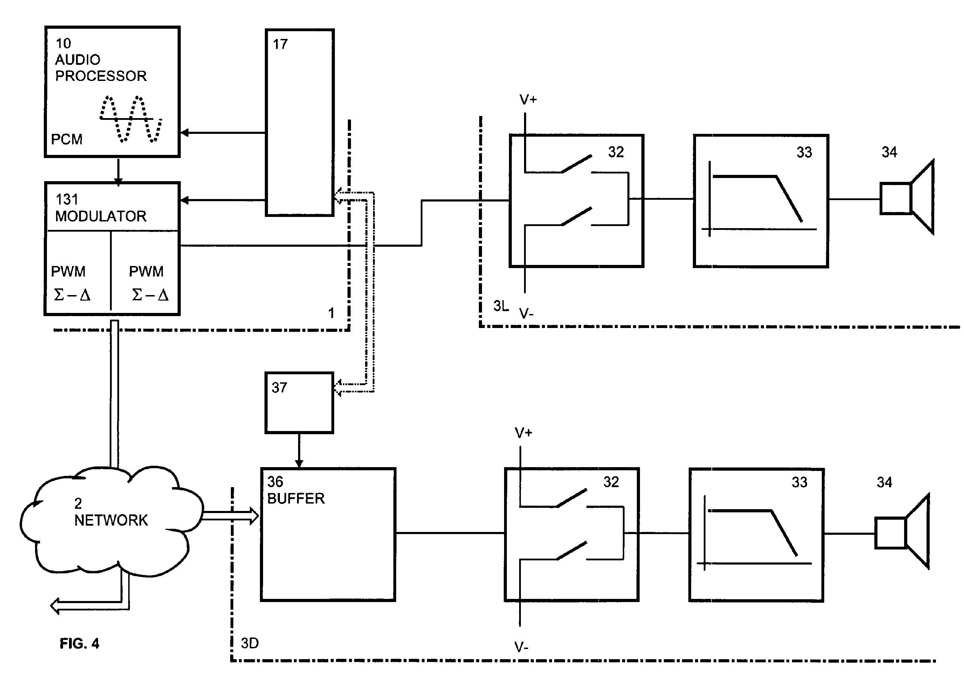

Figure 4 shows the inventive network-based system of figure 3 with a buffer 36 provided (at least) in the destination unit 3D and with synchronised (symbolically shown) clock units 17, 37 in the centralised source unit 1 and in the destination unit 3D. Since variations of transmission times and/or differences or drifts of clock frequencies (f2 = n * fs1, fs3) used in the centralised source unit 1 and in the destination unit 3 may occur, the bit stream of the second digital signal is forwarded to the buffer 36 such as a FIFO-buffer. If the buffer is large enough and the drifts of the clock frequencies are small and the clock frequencies are identical in average no overflow will occur. However, if the frequencies constantly deviate a correction is required which can preferably be performed with one of the methods described below.

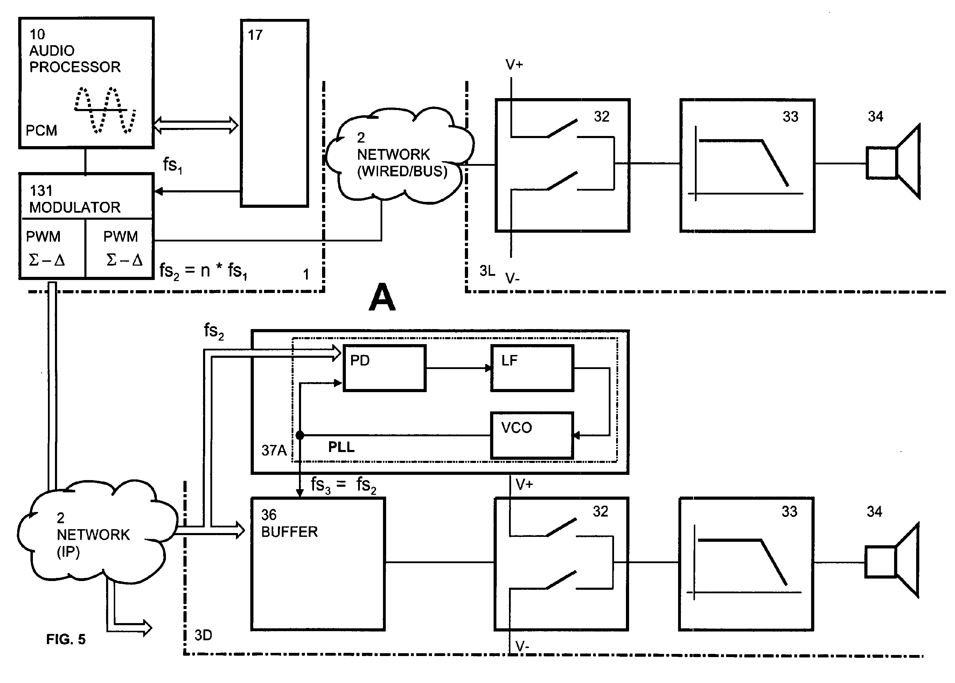

Figure 5 shows the inventive network-based system of figure 4, with a clock recovery unit, which comprises a phase locked loop PLL integrated in the clock unit 37 of the destination unit 3D. Phase Locked Loops PLL, which comprise a phase detector PD, filter LF and a voltage controlled oscillator VCO are described in [3], chapter 76, pages 1727-1734. The clock frequency at the input of the modulator is fs1. At the output, e.g. of a Σ-Δ modulator, the clock frequency fs2 = n * fs1 appears. By means of the phase locked loop PLL the clock frequency fs3 used for the buffer 36 is tracking the clock frequency fs2 of the input signal (fs3 = fs2). Hence, the average rate at which data is entering the buffer 36 is kept identical to the rate at which data is leaving the buffer 36, this avoiding an overflow.

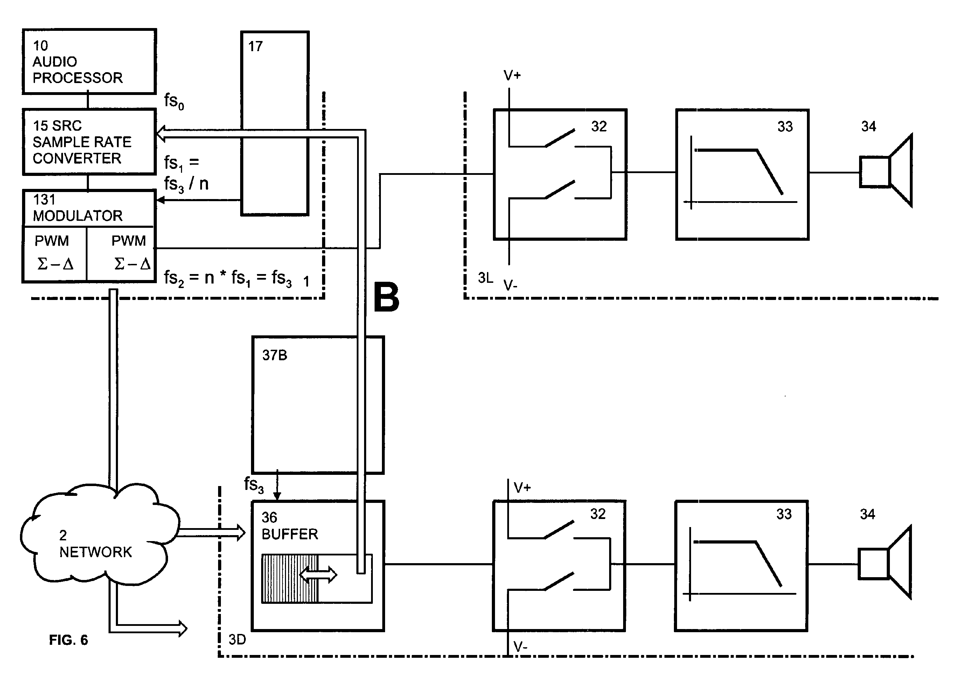

Figure 6 shows the inventive network-based system of figure 4, with a clock and measuring unit 37 provided in the destination unit 3D, which provides a fixed clock signal fs3 to the buffer 36 and which measures and signals the content level of the buffer 36 to the clock unit 17 of the centralised source unit 1 or directly to a sample rate converter 15 therein, which adjusts the sampling frequencies of the related modulator 131 in order to keep the content level within a predetermined range.

As described in [1], chapter 2.4, page 46, generally, there is only one sampling rate used within a digital signal-processing system. Sampling is the process of converting a signal into a numeric sequence (a function of discrete time or space). The Nyquist-Shannon theorem states conditions under which the samples represent no loss of information and can therefore be used to reconstruct the original signal with arbitrarily good fidelity. It states that the signal must be band limited and that the sampling frequency must be at least twice the signal bandwidth. According to [1] a change of the sampling frequency may be desirable under certain conditions. If the bandwidth of the signal is reduced a reduction of the sampling rate saves computing time. In the contrary, the sampling rate is increased, if the bandwidth is expanded or if interpolation efforts shall be reduced.

In the present application the sampling rate or frequency f1; f2 = n * fs1 is changed in the centralised source unit 1 in order to match the sampling frequency f3 applied in the related destination unit 3.

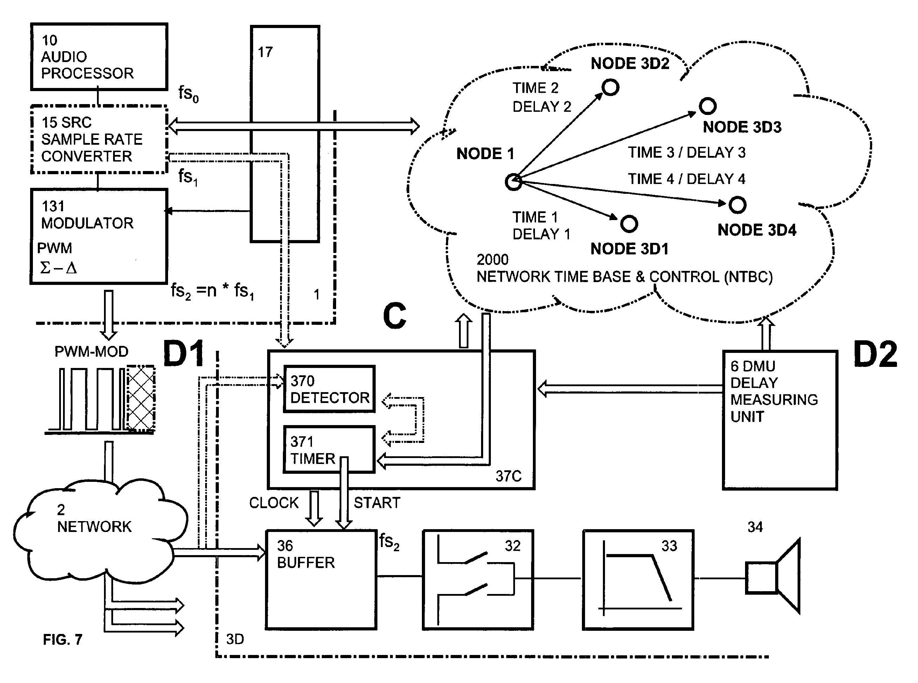

Figure 7 shows the inventive network-based system of figure 4, with a network time base control system 2000 that synchronises local clocks and times in the centralised source unit 1 and in the destination units 3.

Maintaining Synchronization in a Network is described for example in [8], WO 00/0048367. According to [8], network nodes participate in a scheme to maintain synchronization in the network. Such maintenance is needed to compensate for different "drift" rates for each node's timer(s). While maintaining network synchronisation, each node's local Network Time is only adjusted in the forward direction, and the network will roughly track the time of the node in the network that happens to have the fastest clock. The Network Time will switch to tracking the time of the node with the next fastest clock.

Hence with a method as described in [8], all clocks and times can be fully synchronised, which can advantageously be used in the inventive network-based system. Timers 371 provided in the in the individual destination units 3 and preferably also in the centralised source unit 1 are set to and kept at the same time indication. Independent of propagation delays within the network-based system, the start of reading data from the buffers 36 in the destination units 3 can be set to the same time, thus avoiding phase shifts between the signals emitted from the destination units. Although it may normally be optimal to set the start of the reading process for all destination units 3 at the same time setting, it may be advantageous to use different time settings, if the propagation delays outside the network-based system, e.g. within a large concert hall are not balanced.

Further the network-based system shown in figure 7 comprises a delay measuring unit 6, which allows measuring all relevant system delays. The delay measuring unit 6 is preferably located in the centralised source unit 1 and provides the obtained delay information to a process which calculates time settings.

A suitable common clock time can be determined in the centralised source unit 1 in advance based on the reported delays. The determined common clock time can be forwarded to the destination units in a frame such as a header contained in the bit stream of the second digital signal or over a separate control channel.

If the relevant delays are not known, a suitable common clock time can be determined after the start of the transfer of the bit stream of the second digital signal. For this method a header is provided in front of the modulated bit stream, which header can be detected in the destination units and signalled to the centralised source unit 1, which then forwards the determined common start time to the destination units over a separate control channel. When the start time is reached data will be read out simultaneously from all buffers 36, regardless of the level of content in the buffers 36.

Figure 7 shows a header in front of the PWM-modulated bit stream, which may contain a start time or which may simply be used for the detection and signalling of the receipt of the bit stream. For this purpose the PWM-modulated bit stream is forwarded to a detector 370, which detects the receipt of the header and, if present, unpacks the predetermined time which is forwarded to the timer 371.

If all clock frequencies used in the system of figure 7 would be identical, sample rate conversion techniques would not be required. However sampling rates used in media players are normally different from sampling rates that are suitable for the implementation of the inventive solution. Hence, a suitable sampling rate is achieved by means of the sampling rate converter 15, which reports the sampling rate selected to the destination units 3, if this information, e.g. a fixed factor, is not already available there.

The network time base & control system 2000 (NTBC) can be regarded as a separate layer of the inventive network-based system, with timing control signals and timing messages exchanged between nodes that represent the central and peripheral units 1, 3 of the system. In the network time base & control system the local times TIME1, ..., TIME4 and delays DELAY1, ..., DELAY4 may be registered and continuously updated, corrected and synchronised.

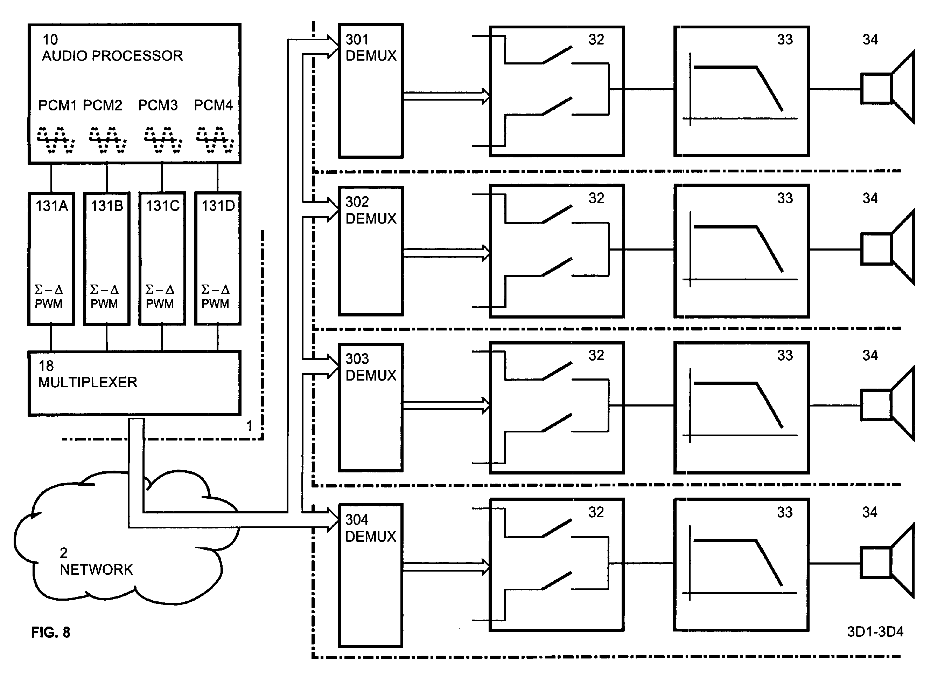

Figure 8 shows symbolically the multiplexing architecture of an inventive network-based system comprising a centralised source unit 1 with a multiplexer 18 and four destination units 3D1, ..., 3D4 with de-multiplexers 301, ..., 304. The multiplexer 18 multiplexes four different bit streams received from modulators 131A, ..., 131D and forwards the resulting bit stream to the demultiplexers 301, ..., 304, which extract the part from the bit stream which is dedicated to the related destination unit 3. For transmission purposes the multiplexed bit stream can be encoded, packetised or compressed.

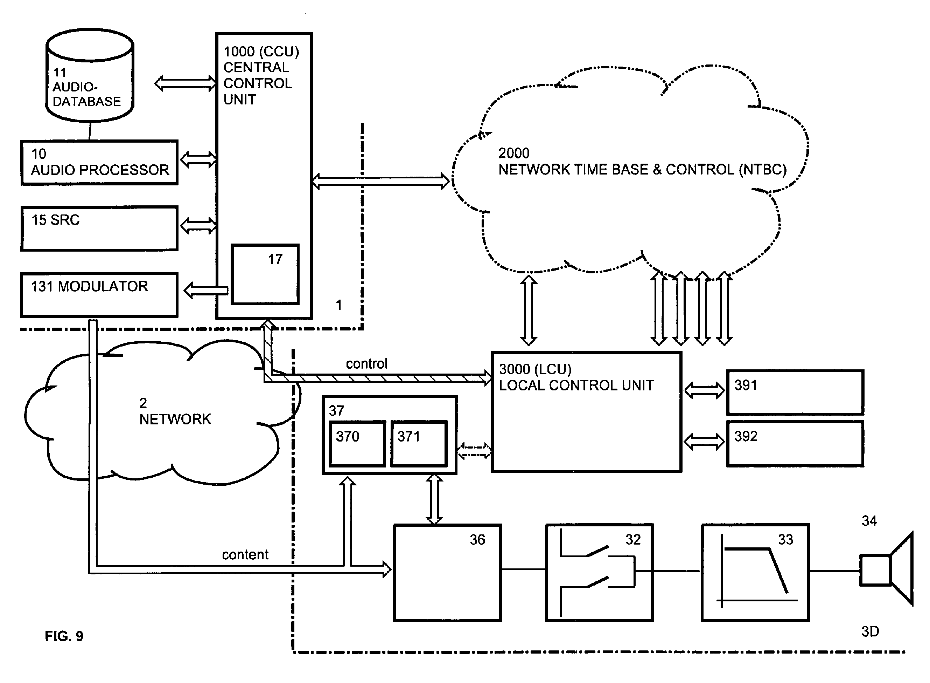

Figure 9 shows the inventive network-based system of figure 7 with a central control unit 1000 provided in the centralised source unit 1 that communicates with the local control unit 3000 of the destination units 3D via a control channel ctrl that is separate from the content channel. The central control unit 1000 preferably allows controlling of all relevant functions and parameters used in the destination unit. The central control unit 1000 may for example control the power supply 391, particularly the supply voltages provided to the switching unit 32 and an input and/or output device 392 such as a display in the destination unit 3.

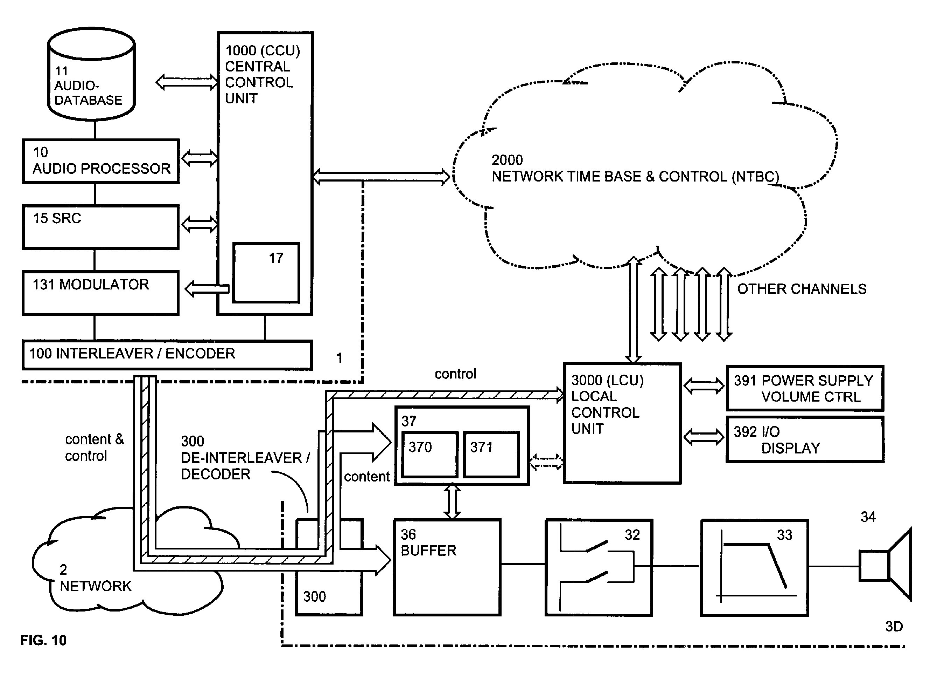

Figure 10 shows the inventive network-based system of figure 7 with the central control unit 1000 provided in the centralised source unit 1 forwarding control signals in-band or interleaved within the packetised modulated bit stream to the local control unit of the destination units 3D. For this purpose an interleaver 100 is provided in the centralised source unit 1, which encloses control signals, e.g. in the packetised stream of modulated content. A control frame or packet may for example be provided after each series of x (e.g., x = 1024) content frames. In the destination unit 3, a de-interleaver is provided, which separates the control data stream and the content stream, which is forwarded to the buffer 36, and if required to the clock unit 37 for detecting start signals or start timings or for any recovery purposes.

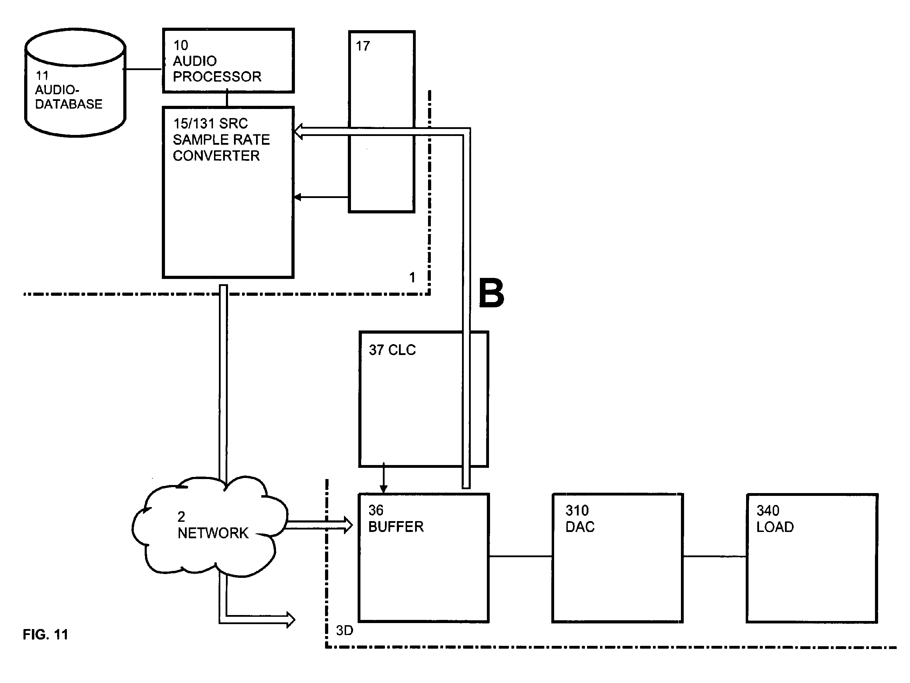

Figure 11 shows a sample rate converter 15/131 provided in the centralised source unit 1 that is used for sample rate conversion and or signal modulation. The sampling rate converter 15/131 is typically operated in high frequency ranges in order to keep quantisation errors and interpolation efforts as low as possible. Converted digital signals are forwarded to the buffer 36, which provides the above described services, in destination unit 3 and further to an digital-to-analog converter 310.

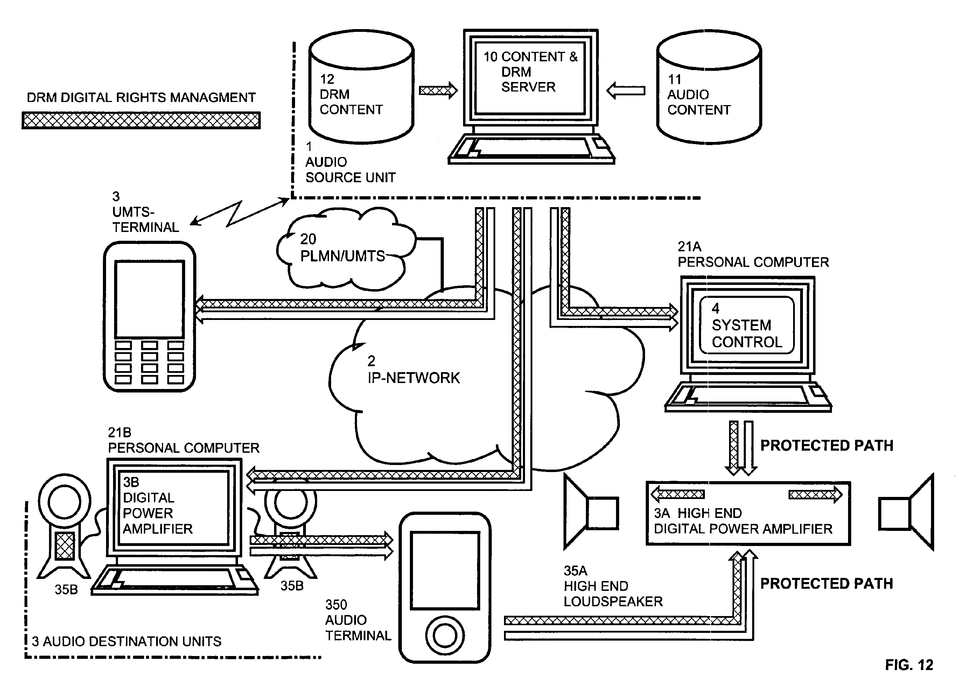

Figure 12 shows the network-based system of figure 2 after the implementation of the inventive solution. It is illustrated that the content is protected by means of the inventive solution without any gap, on the whole transmission path from the centralised source unit 1 to the load, provided in the destination units.

### References

[1] Peter Gerdse, Peter Kröger, Digitale Signalverarbeitung in der Nachrichtenübertragung, 2nd Edition, Berlin 1997
[2] R. Esslinger, G. Gruhler, R.W. Stewart, Digital Power Amplification based on Pulse-Width Modulation and Sigma-Delta Loops, Signal Processing Division, Dept. of Electronic and Electrical Engineering, University of Strathclyde, Glasgow G1 1XW, Scotland
[3] Richard C. Dorf, The Electrical Engineering Handbook, 2nd Edition, CRC Press, 1997 Boca Raton
[4] US 2006/0044057
[5] US 5'898'340
[6] WO 2006/041590
[7] US 6'990'202
[8] WO 00/0048367

## Claims

1. Method for transferring information, particularly audio information, in a network-based system from a centralised source unit (1), particularly an audio source unit, in digital form over at least one network (2),
- a wired network such as a wired bus system; or a
- a wireless or wired switched network providing connection-oriented services; or
- a wireless or wired packet switching network;
to at least one destination unit (3), particularly to an audio destination unit, in which the transferred data are further processed to provide an analogue signal; comprising the steps of
a) providing in the centralised source unit (1) a first digital signal, such as a PCM signal, that has been derived from a first analogue signal;
b) forwarding the first digital signal in the centralised source unit (1) to the input of a modulator (131), which transforms the first digital signal into a second digital signal that consists of a bit stream, whose mean-value represents the information contained in the first digital signal;
c) transferring the second digital signal over said network (2) to the destination unit (3); and
d) forwarding the second digital signal in the destination unit (3) to a low pass filter (33) in order to gain a second analogue signal that corresponds to the first analogue signal.

2. Method according to claim 1 comprising the steps of transforming the first digital signal by means of pulse width modulation or sigma-delta modulation or a derivative thereof or by means of a sample rate conversion into the second digital signal.

3. Method according to claim 1 or 2 comprising the steps of multiplexing, encoding, encrypting and/or packetising the second digital signal in the centralised source unit (1) and de-multiplexing, decoding, decrypting and/or de-packetising the second digital signal in the destination unit (3) accordingly.

4. Method according to claim 1, 2 or 3 comprising the steps of forwarding the second digital signal received in the destination unit (3) to a buffer (32) that serves for the compensation of variations of transmission times and/or the compensation of differences or drifts of clock frequencies (f2 = n * fs1, fs3) used in the centralised source unit (1) and in the destination unit (3).

5. Method according to claim 4 comprising the steps of avoiding or correcting differences of the clock frequencies (f2 = n * fs1, fs2) used in the centralised source unit (1) and in the destination unit (3) preferably by
a) recovering the clock frequency (f2 = n * fs1) of the centralised source unit (1) in the destination unit (3), preferably by means of a phase locked loop; and/or
b) measuring the content level in the buffer (36) and controlling the related clock frequency (f2 = n * fs1, fs2) used in the centralised source unit (1) by means of a sample rate converter (15) in such a way that the content level in the buffer (36) remains within a given range; and/or
c) using a common network time and/or clock for synchronising all relevant system clocks (f1, f2, f3) in the centralised source unit (1) or in the destination units (3).

6. Method according to one of the claims 1 - 5, comprising the steps of measuring and compensating for transmission delays occurring in the network-based system.

7. Method according to one of the claims 1 - 6, comprising the steps of using the common network time for synchronising or, in view of external propagation delays, individually selecting the starts of all readouts from the buffer devices (36) in the destination units (3) by
a) synchronising all clock times used in the network-based system or at least in the destination units (3);
b) determining a common clock time for all destination units (3); and
c) starting to read out the second digital data from the buffers (36) of the individual destination units (3) at the determined a common clock time.

8. Method according to claim 7, comprising the steps
a) determining a suitable common clock time in the centralised source unit (1) in advance based on known delays that have been measured within the network-based system and providing the determined common clock time to the destination units (3) within a frame such as a header contained in the bit stream of the second digital signal or over a separate control channel; or
b) determining a suitable common clock time after the start of the transfer of the bit stream of the second digital signal, and after the detection of a header in the destination units (3), that has been signalled to the centralised source unit (1), which then forwards the determined common clock time to the destination units (3) over a separate control channel.

9. Method according to one of the claims 1 - 8, comprising the steps controlling the network-based system by means of a centralised control unit (1000) that forwards control information over a separate control channel in-band within the stream of the second digital signal to the peripheral destination units (3).

10. Method according to one of the claims 1 - 9, comprising the steps of forwarding the second digital signal over a switching stage (32) to the low pass filter (33) which provides the second analogue signal to a load (34) such as a loudspeaker.

11. Network-based system operating accord to a method as defined in one of the claims 1-10, with a centralised source unit (1), particularly an audio source unit (10), designed for transferring information, particularly audio information in digital form over a network (2), said network being
- a wired network such as a wired bus system; or a
- a wireless or wired switched network providing connection-oriented services; or
- a wireless or wired packet switching network;
to at least one destination unit (3), particularly to an audio destination unit, in which the transferred data are further processed to provide an analogue signal; **characterised in that**
the centralised source unit (1) comprises a modulator (131), designed to transform a first digital signal, such as a PCM signal, that has been derived from a first analogue signal, into a second digital signal that consists of a bit stream, whose mean-value represents the information contained in the first digital signal; and that
the destination unit (3) comprises a low pass filter (33), which receives the second digital signal at its input and which delivers a second analogue signal that corresponds to the first analogue signal.

12. Network-based system according to claim 11 wherein the modulator is designed to transform the first digital signal by means of pulse width modulation or sigma-delta modulation or derivatives thereof or by means of a sample rate conversion into the second digital signal.

13. Network-based system according to claim 11 or 12, with a at least one processing module (18, 100) provided in the centralised source unit (1), designed for multiplexing, encoding, encrypting and/or packetising the second digital signal and with at least one processing module (300; 301, ...) provided in the destination unit (3), designed for de-multiplexing, decoding, decrypting and/or de-packetising the second digital signal in the destination unit (3) accordingly.

14. Network-based system according to claim 11, 12 or 13, with a buffer (32) provided in the destination unit (3) for receiving and partially storing the second digital signal in order to compensate for variations of transmission times and/or to compensate for differences or drifts of clock frequencies (f2 = n * fs1, fs3) used in the centralised source unit (1) and in the destination unit (3).

15. Network-based system according to claim 14, comprising clock and synchronisation modules (17, 37, 2000) designed for avoiding or correcting differences of the clock frequencies (f2 = n * fs1, fs2) used in the centralised source unit (1) and in the destination unit (3), such as
a) a clock recovery unit (37A) provided in the destination unit (3), preferably comprising a phase locked loop designed for extracting the clock frequency from the second digital signal and for adjusting the local clock frequency accordingly; and/or
b) a clock and measuring device (37B) provided in the destination unit (3), designed for providing a fixed clock frequency; for measuring the content level in the buffer (36) and for providing a corresponding control signal, which is forwarded to a sample rate converter (15) provided in the centralised source unit (1), that is used for adjusting the sampling rate of the first or second digital signal accordingly; and/or
c) a network time base and control system (2000) designed for providing a common network time and/or clock in the centralised source unit (1) and the individual destination units (3).

16. Network-based system according to one of the claims 11 - 15, comprising at least one delay compensation device (6) designed for measuring and compensating for transmission delays occurring in the network-based system.

17. Network-based system according to one of the claims 1 - 16, comprising timers (371) in the destination devices (3) that are used for setting a common or, in view of external propagation delays, individually selected start time for all readouts from the buffer devices (36) in the destination units (3) by

18. Network-based system according to one of the claims 1 - 17, comprising a switching stage (32) and a low pass filter (33), which provides the second analogue signal to a load (34) such as a loudspeaker.
